# EUROPÄISCHE PATENTSCHRIFT

(11) **EP 3 813 500 B1**
(45) Veröffentlichungstag und Bekanntmachung des Hinweises auf die Patenterteilung: **20.09.2023**
(21) Anmeldenummer: 19205170.4
(22) Anmeldetag: 24.10.2019
(51) Int. Cl.: H05K 5/02

(54) **LÜFTUNGSVORRICHTUNG MIT SPRITZWASSERSCHUTZ UND ARBEITSGERÄT MIT EINER SOLCHEN LÜFTUNGSVORRICHTUNG**
VENTILATION DEVICE WITH SPLASH WATER PROTECTION AND WORKING DEVICE COMPRISING SUCH A VENTILATION DEVICE
DISPOSITIF D'AÉRATION POURVU DE PROTECTION CONTRE L'EAU DE PULVÉRISATION ET APPAREIL DE TRAVAIL DOTÉ D'UN TEL DISPOSITIF D'AÉRATION

(43) Veröffentlichungstag der Anmeldung: 28.04.2021
(73) Patentinhaber: Andreas Stihl AG & Co. KG, 71336 Waiblingen (DE)
(72) Erfinder: WERNER, Philipp, 71334 Waiblingen (DE); KNAUSS, Jens, 73630 Remshalden (DE); BAUMHACKL, Yannik, 71737 Kirchberg Murr (DE); BECK, David, 71364 Winnenden (DE)
(74) Vertreter: Karzel, Philipp

(56) Entgegenhaltungen:
- EP-B1- 0 873 199
- WO-A1-97/23308
- WO-A1-2013/123968
- CN-U- 201 533 475
- FR-A1- 3 036 249
- US-A1- 2007 076 356
- US-A1- 2012 024 594

## Beschreibung

Die Erfindung betrifft eine Lüftungsvorrichtung nach Anspruch 1 und ein Arbeitsgerät mit einer solchen Lüftungsvorrichtung.

Derartige Lüftungsvorrichtungen werden typischerweise aus Kunststoff hergestellt. Hierbei ist es vorteilhaft, wenn die Lüftungsvorrichtung bezüglich einer Entformungsrichtung ohne Hinterschnitte gestaltet ist. Dann kann die Lüftungsvorrichtung auf einfache Weise entformt werden. Lüftungsschlitze einer solchen Lüftungsvorrichtung erstrecken sich quer zur Entformungsrichtung. Die Lüftungsvorrichtung weist eine Innenseite und eine Außenseite auf. Um von der Außenseite vordringendes Spritzwasser zumindest teilweise abweisen zu können, weist die Lüftungsvorrichtung einen Abweisungsabschnitt auf, der sich quer zur Entformungsrichtung erstreckt. In Blickrichtung der Entformungsrichtung deckt der Abweisungsabschnitt einen zugeordneten Lüftungsschlitz ab. Lüftungsschlitz und Abweisungsabschnitt sind in Entformungsrichtung in einem Abstand zueinander angeordnet. Im Betrieb der Lüftungsvorrichtung, die typischerweise in Hochdruckreinigern eingesetzt wird, kann dennoch eine große Menge Spritzwasser auf die Innenseite der Lüftungsvorrichtung vordringen.

Aus der WO 97/23308 A1 sind labyrinthartig ausgebildete Lüftungsschlitze bekannt, deren Öffnungen auf der Innenseite der Lüftungsvorrichtung mittels einer beabstandet angeordneten Abdeckung zum Schutz der Innenseite vor Spritzwasser abgedeckt sind.

Aus der FR 3 036 249 A1 ist ein Schaltkasten mit einem Belüftungssystem mit Wasserschutz bekannt. Der Wasserschutz ist durch nach oben abgewinkelte Abschnitte der die Lüftungsschlitze begrenzenden Lamellen gebildet.

Aus der CN 201 533 475 U1 ist eine Belüftungsvorrichtung mit Lamellen bekannt, die an der Innenseite nach oben abgewinkelt sind.

Aus der US 2007/0076356 A1 ist ein elektronisches Gerät mit einem Lüftungssystem bekannt, das eine Vorrichtung zur Vermeidung von Staubeintritt umfasst. Zu diesem Zweck weisen die die Lüftungsschlitze begrenzenden Lamellen an ihren Innenseiten nach oben abgewinkelte Abschnitte auf.

Aus der US 2012/0024594 A1 ist eine Lüftungsvorrichtung mit Lamellen bekannt, die an ihrer Innenseite nach oben abgewinkelt sind.

Aus der WO 2013/123968 A1 ist ein Hochdruckreinigungsgerät mit einer Lüftungsvorrichtung bekannt, die einen Spritzschutz mit Schlitzen aufweist.

Der Erfindung liegt die Aufgabe zugrunde, eine gattungsgemäße Lüftungsvorrichtung derart weiterzubilden, dass eine große Menge Spritzwasser am Vordringen auf die Innenseite der Lüftungsvorrichtung gehindert wird.

Diese Aufgabe wird durch eine Lüftungsvorrichtung mit den Merkmalen des Anspruchs 1 gelöst.

Eine weitere Aufgabe der Erfindung liegt darin, ein Arbeitsgerät mit einer Lüftungsvorrichtung anzugeben, bei dem die Lüftungsvorrichtung derart gestaltet ist, dass eine große Menge Spritzwasser am Vordringen auf die Innenseite der Lüftungsvorrichtung gehindert wird.

Diese Aufgabe wird durch ein Arbeitsgerät mit den Merkmalen des Anspruchs 15 gelöst.

Die Erfindung sieht vor, dass der Abweisungsabschnitt einen Bereich aufweist, der gegenüber dem Mittelabschnitt in einem Winkel von kleiner als 90° orientiert ist. Der Erfindung liegt die Erkenntnis zugrunde, dass ein wesentlicher Teil des Spritzwassers am Abweisungsabschnitt abprallt und zurückgeworfen wird. Hierbei findet eine Art Reflektion des Spritzwassers am Abweisungsabschnitt statt. Auch bei dieser Reflektion des Spritzwassers gilt, dass der Ausfallswinkel des Spritzwassers bezüglich einer Tangentialebene des Abweisungsabschnitts dem Einfallswinkel bezüglich dieser Ebene entspricht. Durch die Orientierung des Bereichs des Abweisungsabschnitts in einem Winkel von kleiner als 90° gegenüber dem Mittelabschnitt wird auf den Abweisungsabschnitt treffendes Spritzwasser mit größerer Wahrscheinlichkeit in Richtung auf den Mittelabschnitt zurückgeworfen als in Richtung von dem Mittelabschnitt weg. Dies führt dazu, dass eine große Teilmenge des durch einen Lüftungsschlitz eindringenden Spritzwassers die Lüftungsvorrichtung wieder durch diesen Lüftungsschlitz verlässt. Dadurch kann die Menge des auf die Innenseite der Lüftungsvorrichtung vordringenden Spritzwassers reduziert werden.

Vorteilhaft sind der Bereich des Abweisungsabschnitts und der Mittelabschnitt in einem Winkel von kleiner als 60° zueinander orientiert.

Zweckmäßig überlappt der Abweisungsabschnitt einen zugeordneten Lüftungsschlitz in Blickrichtung von der Außenseite zur Innenseite zumindest teilweise. Es kann auch vorgesehen sein, dass der Abweisungsabschnitt den Lüftungsschlitz vollständig überlappt. Zweckmäßig entspricht die Blickrichtung einer Entformungsrichtung in der die Formteile bei der Herstellung einer Lüftungsvorrichtung aus Kunststoff entformt werden. Durch die Überlappung des Abweisungsabschnitts und des zugeordneten Lüftungsschlitzes trifft in Blickrichtung bzw. in Entformungsrichtung eindringendes Spritzwasser auf den Abweisungsabschnitt.

Der Mittelabschnitt und der Abweisungsabschnitt weisen eine zur Außenseite zeigende gemeinsame Oberfläche auf. In vorteilhafter Weiterbildung der Erfindung ist vorgesehen, dass die gemeinsame Oberfläche in einem Querschnitt senkrecht zur Längsrichtung der mindestens einen Lamelle konkav ist. Die Längsrichtung der mindestens einen Lamelle erstreckt sich quer, insbesondere senkrecht zur Entformungsrichtung. Durch die konkave Form der gemeinsamen Oberfläche kann Spritzwasser, das mit einer geringen Geschwindigkeit auf den Mittelabschnitt trifft, entlang der konkaven Oberfläche geführt werden und hierbei eine Richtungsänderung in Richtung auf den Lüftungsschlitz zurück erfahren.

Zweckmäßig folgt die gemeinsame Oberfläche im Querschnitt senkrecht zur Längsrichtung der mindestens einen Lamelle abschnittsweise einer Kreisbogenlinie.

Zweckmäßig liegen die Frontabschnitte in einer gemeinsamen Ebene. In vorteilhafter Weiterbildung der Erfindung ist vorgesehen, dass die Ebene in der Arbeitslage in einem Winkel von 30° bis 60° gegen einen ebenen Boden orientiert ist. Dadurch kann die Lüftungsvorrichtung in einem geringen Abstand zum Boden platziert sein und dennoch gekippt werden.

Zweckmäßig verläuft der Mittelabschnitt in der Arbeitslage quer zur Vertikalrichtung, insbesondere senkrecht zur Vertikalrichtung.

Vorteilhaft sind mehrere Lamellen mit einem Mittelabschnitt und einem Abweisungsabschnitt vorgesehen.

In vorteilhafter Weiterbildung der Erfindung ist vorgesehen, dass zumindest ein Abweisungsabschnitt so geformt und angeordnet ist, dass in Arbeitslage Wasser von einer der Außenseite zugewandten Außenfläche des Abweisungsabschnitts auf den Mittelabschnitt einer benachbarten Lamelle tropfen kann. Insbesondere sind die mehreren Lamellen treppenartig angeordnet. Zweckmäßig ist der mindestens eine Abweisungsabschnitt auf der Innenseite derart geformt, dass in der Arbeitslage Wasser von einer der Innenseite zugewandten Innenfläche des Abweisungsabschnitts auf die benachbarte Lamelle tropfen kann. Dadurch kann Spritzwasser, das auf die Innenseite der Lüftungsvorrichtung vorgedrungen ist, von einer Lamelle auf eine darunter liegende benachbarte Lamelle tropfen. Auf diese Weise kann sich das Wasser an einem unten liegenden Punkt der Lüftungsvorrichtung sammeln. Dieser Punkt kann an einer Stelle angeordnet sein, an dem das Spritzwasser unschädlich ist. Ebenfalls kann vorgesehen sein, das auf die Innenseite vorgedrungene Spritzwasser von diesem Punkt zur Außenseite der Lüftungsvorrichtung hin abzuführen.

Zweckmäßig liegen die Mittelabschnitte der mehreren Lamellen in der Arbeitslage in Vertikalrichtung zumindest abschnittsweise nebeneinander, insbesondere abschnittsweise parallel nebeneinander. Dadurch können die Lamellen insbesondere auf einfache Weise hergestellt werden. Insbesondere ist eine einfache Entformbarkeit bei einer Lüftungsvorrichtung aus Kunststoff möglich.

Zweckmäßig weisen die mehreren Lamellen die gleiche Form auf.

Die mehreren Lamellen umfassen eine erste Lamelle und eine zweite Lamelle. Der Mittelabschnitt der ersten Lamelle weist eine der Außenseite der Lüftungsvorrichtung zugewandte erste Oberfläche auf. Der Mittelabschnitt der zweiten Lamelle weist eine der Außenseite der Lüftungsvorrichtung zugewandte zweite Oberfläche auf. Die zweite Oberfläche weist zur ersten Oberfläche einen ersten Abstand auf. Vorteilhaft erstreckt sich zumindest der Frontabschnitt der zweiten Lamelle über einen Frontbereich von mindestens 30%, insbesondere von mindestens 40% des ersten Abstands.

Insbesondere umfassen die mehreren Lamellen eine dritte Lamelle. Insbesondere weist die zweite Oberfläche des Mittelabschnitts der zweiten Lamelle zu einer dritten Oberfläche eines Mittelabschnitts der dritten Lamelle einen zweiten Abstand auf. Vorteilhaft erstreckt sich zumindest der Abweisungsabschnitt der zweiten Lamelle über einen Abweisungsbereich von mindestens 30%, insbesondere von mindestens 40% des zweiten Abstands.

Das erfindungsgemäße Arbeitsgerät ist für den Arbeitseinsatz in einer Abstelllage auf einem ebenen Boden abstellbar. Die Lüftungsvorrichtung ist in der Abstelllage des Arbeitsgeräts in der Arbeitslage. Insbesondere ist vorgesehen, dass das Arbeitsgerät ein Hochdruckreiniger ist.

Das Arbeitsgerät weist bezüglich des Bodens ein oberes Ende und ein unteres Ende auf. Vorteilhaft ist die Lüftungsvorrichtung am unteren Ende des Arbeitsgeräts angeordnet. Bei einer solchen Anordnung der Lüftungsvorrichtung ist die Orientierung der Mittelabschnitte und der Abweisungsabschnitte besonders vorteilhaft. Dadurch kann verhindert werden, dass Spritzwasser in den Bereich oberhalb der Lüftungsvorrichtung vordringt.

In vorteilhafter Weiterbildung der Erfindung ist vorgesehen, dass das Arbeitsgerät ein Gehäuse mit einer Gehäusewand aufweist, dass die Lüftungsvorrichtung Teil der Gehäusewand ist, dass auf der Innenseite der Lüftungsvorrichtung das Gehäuseinnere des Gehäuses angeordnet ist, dass die Außenseite der Lüftungsvorrichtung außerhalb des Gehäuses liegt, und dass das Arbeitsgerät durch die Lüftungsvorrichtung von der Außenseite Luft auf die Innenseite anzieht.

Insbesondere weist das Arbeitsgerät mindestens ein elektrisch betriebenes Bauteil auf. Zweckmäßig ist die Lüftungsvorrichtung in der Abstelllage zumindest teilweise unterhalb aller elektrisch betriebenen Bauteile angeordnet. Dadurch liegen sämtliche elektrisch betriebene Bauteile oberhalb der Lüftungsvorrichtung und sind durch den Spritzwasserschutz der Lüftungsvorrichtung vor Spritzwasser geschützt.

Ein Ausführungsbeispiel der Erfindung wird im Folgenden anhand der Zeichnung erläutert. Es zeigen:
- Fig. 1: eine perspektivische Darstellung eines Hochdruckreinigers,
- Fig. 2 bis 4: perspektivische Darstellungen von einem Teil des Hochdruckreinigers nach Fig. 1,
- Fig. 5: eine Seitenansicht auf das Gehäuse des Hochdruckreinigers nach Fig. 1,
- Fig. 6: einen Teilausschnitt der Seitenansicht nach Fig. 5,
- Fig. 7: eine dreidimensionale Darstellung eines Schnitts entlang der in Fig. 6 mit VII-VII bezeichneten Schnittebene,
- Fig. 8 und 9: Seitenansichten auf den Schnitt entlang der in Fig. 6 mit VII-VII bezeichneten Schnittebene,
- Fig. 10: eine vergrößerte Darstellung eines Details der Schnittdarstellung aus Fig. 8 im Bereich der Lüftungsvorrichtung,
- Fig. 11: eine perspektivische Ansicht auf eine Innenseite der Lüftungsvorrichtung nach Fig. 10.

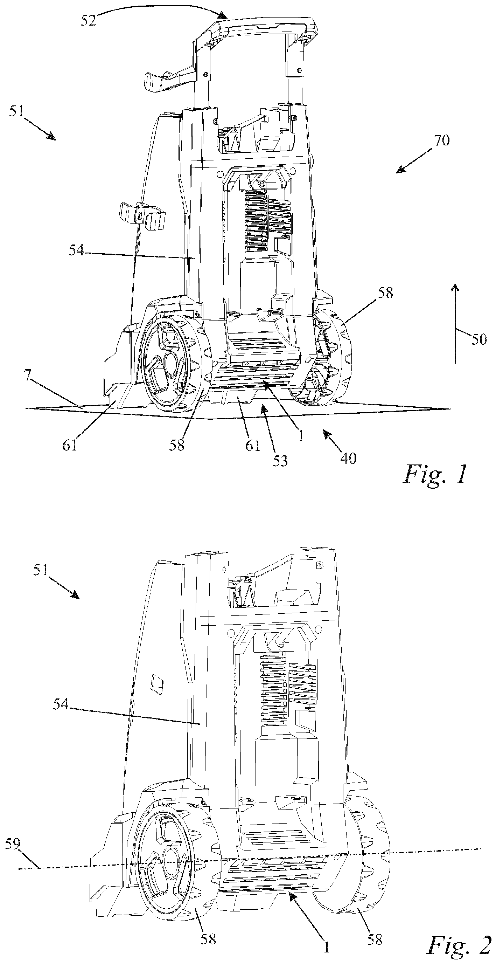

Die Figuren 1 und 2 zeigen das Arbeitsgerät 51. Das Arbeitsgerät 51 ist ein Hochdruckreiniger. Es kann auch vorgesehen sein, dass das Arbeitsgerät ein Sprühgerät, ein Rasenmäher, ein Rasenmähroboter oder ein Kehrgerät ist.

Wie in Fig. 1 dargestellt, ist das Arbeitsgerät 51 für den Arbeitseinsatz in einer Abstelllage 70 auf einem ebenen Boden 7 abstellbar. Das Arbeitsgerät 51 weist bezüglich des Bodens 7 ein oberes Ende 52 und ein unteres Ende 53 auf. Das obere Ende 52 und das untere Ende 53 sind die Längsenden des Arbeitsgeräts 51. Das Arbeitsgerät 51 umfasst eine Lüftungsvorrichtung 1. Die Lüftungsvorrichtung 1 ist am unteren Ende 53 des Arbeitsgeräts 51 angeordnet. Das Arbeitsgerät 51 umfasst zwei Räder 58. Die beiden Räder 58 sind um eine gemeinsame Drehachse 59 drehbar. Die Räder 58 sind an einem Gehäuse 54 des Arbeitsgeräts 51 gelagert. Das Arbeitsgerät 51 umfasst zwei Stützfüße 61. Die Stützfüße 61 sind mit dem Gehäuse 54 verbunden. In der Abstelllage 70 des Arbeitsgeräts 51 ist das Arbeitsgerät 51 auf den Rädern 58 und den Stützfüßen 61 auf dem Boden 7 abgestellt. Der Boden 7 ist eben und erstreckt sich in der Horizontalebene.

In der Abstelllage 70 des Arbeitsgeräts 1 ist die Lüftungsvorrichtung 51 in einer Arbeitslage 40 angeordnet.

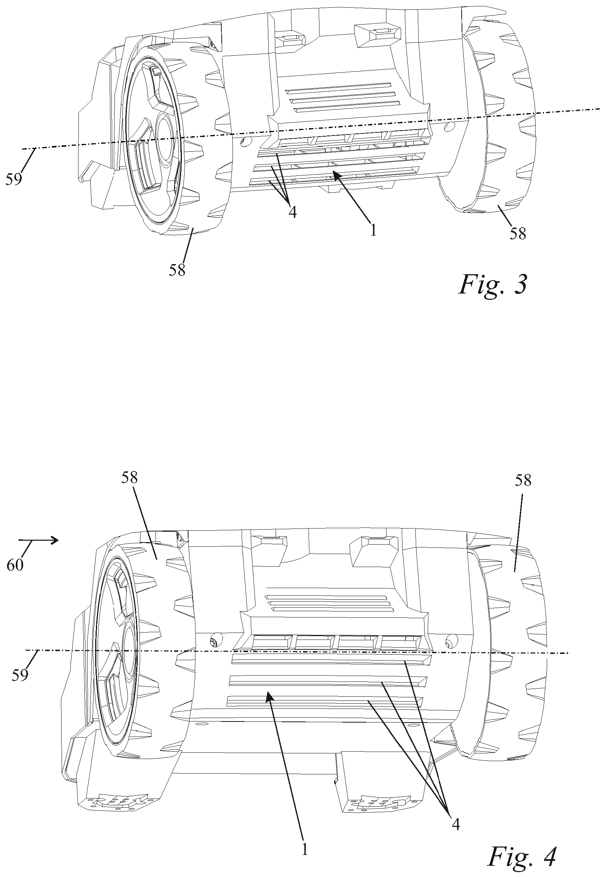

Wie in den Figuren 3 und 4 dargestellt, weist die Lüftungsvorrichtung 1 mehrere Lüftungsschlitze 4 auf. Im Ausführungsbeispiel weist die Lüftungsvorrichtung 1 drei Lüftungsschlitze 4 auf. Der Lüftungsschlitz 4 erstreckt sich in der Arbeitslage 40 der Lüftungsvorrichtung 1 längs einer Längsrichtung 60. Im Ausführungsbeispiel verläuft die Längsrichtung 60 in Richtung der Drehachse 59 der Räder 58.

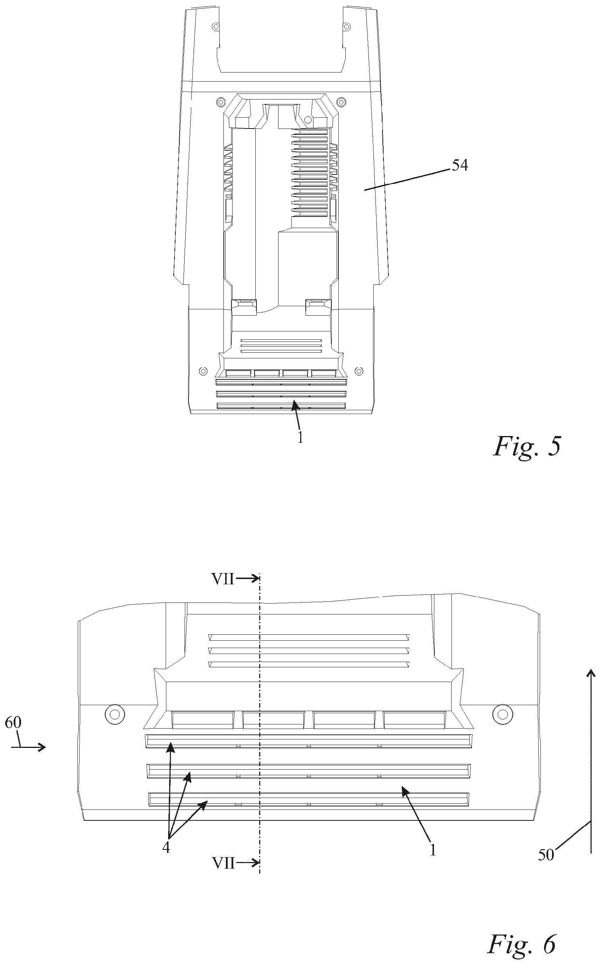

Fig. 5 zeigt das Gehäuse 54 des Arbeitsgeräts 51 in einer Seitenansicht mit Blickrichtung auf die Lüftungsvorrichtung 1. Fig. 6 zeigt eine vergrößerte Darstellung eines Ausschnitts aus Fig. 5. Die Lüftungsschlitze 4 liegen nebeneinander. Alle Lüftungsschlitze 4 erstrecken sich in Längsrichtung 60. Die Lüftungsschlitze 4 verlaufen parallel zueinander. In der Arbeitslage 40 verlaufen die Lüftungsschlitze 4 quer, im Ausführungsbeispiel senkrecht zur Vertikalrichtung 50. Die Lüftungsschlitze 4 liegen in einer Vertikalrichtung 50 nebeneinander. Die Vertikalrichtung 50 steht senkrecht auf dem ebenen Boden 7.

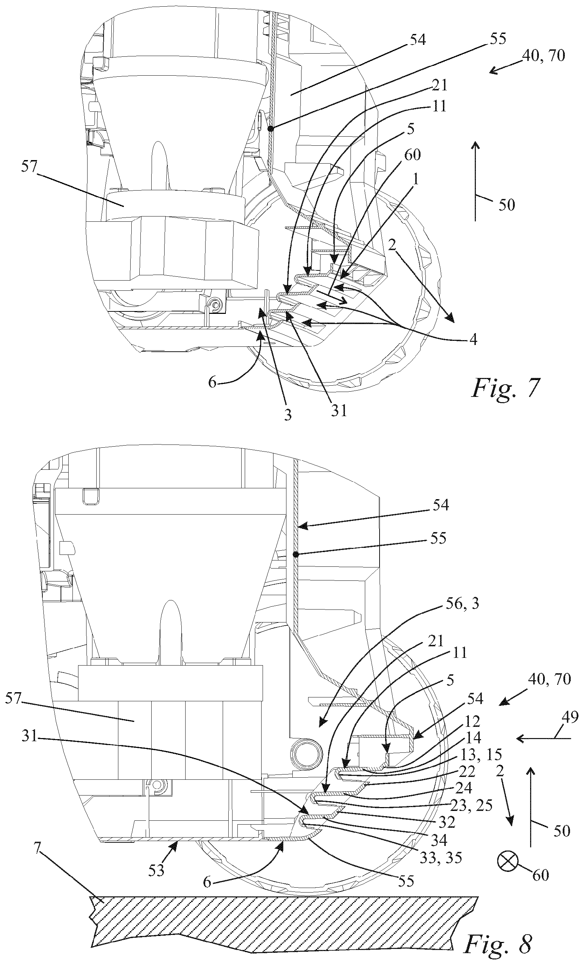

Die Schnittdarstellungen der Figuren 7 und 8 zeigen, dass das Gehäuse 54 des Arbeitsgeräts 51 eine Gehäusewand 55 besitzt. Die Lüftungsvorrichtung 1 ist Teil der Gehäusewand 55. Die Lüftungsvorrichtung 1 besitzt eine Innenseite 3 und eine Außenseite 2. Auf der Innenseite 3 der Lüftungsvorrichtung 1 ist das Gehäuseinnere 56 des Gehäuses 54 angeordnet. Die Außenseite 2 der Lüftungsvorrichtung 1 liegt außerhalb des Gehäuses 54.

Das Arbeitsgerät 51 weist mindestens ein elektrisch betriebenes Bauteil 57 auf. Im Ausführungsbeispiel ist das mindestens eine elektrisch betriebene Bauteil eine Pumpe. Die Pumpe erzeugt den nötigen Druck für die mit dem Hochdruckreiniger zu verspritzende Reinigungsflüssigkeit. Die Lüftungsvorrichtung 1 ist in der Abstelllage 70 zumindest teilweise unterhalb aller elektrisch betriebener Bauteile 57 angeordnet. Der tiefste Punkt der Lüftungsvorrichtung 1 liegt unterhalb aller elektrisch betriebener Bauteile 57. Dadurch wird verhindert, dass durch die Lüftungsschlitze 4 der Lüftungsvorrichtung 1 eindringendes Spritzwasser von oben auf elektrisch betriebene Bauteile 57 tropfen kann. Zur Kühlung des mindestens einen elektrisch betriebenen Bauteils 57 zieht das Arbeitsgerät 51 durch die Lüftungsvorrichtung 1 von der Außenseite 2 Luft auf die Innenseite 3 der Lüftungsvorrichtung 1 an.

Wie in Fig. 7 dargestellt, umfasst die Lüftungsvorrichtung 1 mehrere nebeneinander angeordnete Lamellen 11, 21, 31. Die Lamellen 11, 21, 31 sind Bestandteil der Gehäusewand 55 des Arbeitsgeräts 51. Die Lüftungsvorrichtung 1, insbesondere die Lamellen 11, 21, 31 sind aus Kunststoff. Das Gehäuse 54 des Arbeitsgeräts 51 ist aus Kunststoff. Die Lüftungsvorrichtung 1 umfasst die erste Lamelle 11. Die Lüftungsvorrichtung 1 umfasst die zweite Lamelle 21. Die Lüftungsvorrichtung 1 umfasst die dritte Lamelle 31. Jede der Lamellen 11, 21, 31 weist an der Außenseite 2 der Lüftungsvorrichtung 1 einen Frontabschnitt 12, 22, 32 auf. Die erste Lamelle 11 weist den ersten Frontabschnitt 12 auf. Die zweite Lamelle 21 weist den zweiten Frontabschnitt 22 auf. Die dritte Lamelle 31 weist den dritten Frontabschnitt 32 auf. Zwischen den Frontabschnitten 12, 22, 32 sind die Lüftungsschlitze 4 ausgebildet.

Die Lamelle 11, 21, 31 weist auf der Innenseite 3 einen Abweisungsabschnitt 13, 23, 33 auf. Die erste Lamelle 11 weist den ersten Abweisungsabschnitt 13 auf. Die zweite Lamelle 21 weist den zweiten Abweisungsabschnitt 23 auf. Die dritte Lamelle 31 weist den dritten Abweisungsabschnitt 33 auf. Der Abweisungsabschnitt 13, 23, 33 ist über einen Mittelabschnitt 14, 24, 34 der Lamelle 11, 21, 31 mit dem Frontabschnitt 12, 22, 32 verbunden. Die erste Lamelle 11 weist den ersten Mittelabschnitt 14 auf. Die zweite Lamelle 21 weist den zweiten Mittelabschnitt 24 auf. Die dritte Lamelle 31 weist den dritten Mittelabschnitt 34 auf. Der Frontabschnitt 12, 22, 32 ist gegenüber dem Mittelabschnitt 14, 24, 34 abgewinkelt. "Abgewinkelt" bedeutet in diesem Zusammenhang nicht zwangsläufig, dass zwischen dem Frontabschnitt und dem Mittelabschnitt eine Kante ausgebildet ist. Der Begriff "abgewinkelt" ist so zu verstehen, dass an den Frontabschnitt von der Außenseite her eine Berührebene gelegt werden kann, und dass an dem Mittelabschnitt ebenfalls von der Außenseite her eine Berührebene gelegt werden kann, und dass die beiden Berührebenen schräg zueinander orientiert sind. Der Frontabschnitt 12, 22, 32 ist im Ausführungsbeispiel gegenüber dem Mittelabschnitt 14, 24, 34 dadurch abgewinkelt, dass der Frontabschnitt 12, 22, 32 durch eine abgerundete oder gebogene Form in den Mittelabschnitt 14, 24, 25 übergeht.

Der Abweisungsabschnitt 13, 23, 33 ist gegenüber dem Mittelabschnitt 14, 24, 34 abgewinkelt. Die Bedeutung des Begriffs "abgewinkelt" in diesem Zusammenhang ist analog zu der Verwendung des Begriffs im Zusammenhang mit dem Frontabschnitt und dem Mittelabschnitt zu verstehen.

Die Lamelle 11, 21, 31 umfasst den Frontabschnitt 12, 22, 32, den Abweisungsabschnitt 13, 23, 33 und den Mittelabschnitt 14, 24, 34.

Die Lüftungsvorrichtung 1 besitzt, wie in Fig. 8 dargestellt, die Arbeitslage 40. Wenn die Lüftungsvorrichtung 1 in der Arbeitslage 40 ist, befindet sich das Arbeitsgerät 51 in der Abstelllage 70. Die Oberfläche des Bodens 7 erstreckt sich senkrecht zu der Vertikalrichtung 50. Die Lüftungsvorrichtung 1 besitzt in der Arbeitslage 40 bezüglich der Vertikalrichtung 50 eine Oberseite 5 und eine Unterseite 6. Die Oberseite 5 der Lüftungsvorrichtung 1 ist dem oberen Ende 52 des Arbeitsgeräts 51 zugewandt. Die Unterseite 6 der Lüftungsvorrichtung 1 ist dem unteren Ende 53 des Arbeitsgeräts 51 zugewandt.

Der Frontabschnitt 12, 22, 32 erstreckt sich in der Arbeitslage 40 vom Mittelabschnitt 14, 24, 34 in Richtung auf die Oberseite 5 der Lüftungsvorrichtung 1. Der Frontabschnitt 12, 22, 32 ist in der Arbeitslage 40 der Lüftungsvorrichtung vom Mittelabschnitt 14, 24, 34 weg in Richtung auf die Oberseite 5 der Lüftungsvorrichtung 1 abgewinkelt. Der Abweisungsabschnitt 13, 23, 33 erstreckt sich in der Arbeitslage 40 der Lüftungsvorrichtung 1 vom Mittelabschnitt 14, 24, 34 in Richtung auf die Unterseite 6. Der Abweisungsabschnitt 13, 23, 33 ist in der Arbeitslage 40 der Lüftungsvorrichtung 1 vom Mittelabschnitt 14, 24, 34 weg in Richtung auf die Unterseite 6 der Lüftungsvorrichtung 1 abgewinkelt. Durch die mehreren nebeneinander angeordneten Lamellen 11, 21 und 31 ist ein Spritzwasserschutz zur zumindest teilweisen Abweisung von von der Außenseite 2 der Lüftungsvorrichtung 1 in Richtung auf die Innenseite 3 der Lüftungsvorrichtung 1 vordringendem Spritzwasser gebildet. Wie in Fig. 7 dargestellt, erstrecken sich die Lamellen 11, 21, 31 längs der Längsrichtung 60. Wie aus Fig. 8 ersichtlich, erstreckt sich die Längsrichtung 60 parallel zur Oberfläche des Bodens 7.

Der Abweisungsabschnitt 13, 23, 33 überlappt einen zugeordneten Lüftungsschlitz 4 in Blickrichtung 49 von der Außenseite 2 zur Innenseite 3 zumindest teilweise. Die Blickrichtung 49 ist senkrecht zur Längsrichtung 60 orientiert. Die Blickrichtung 49 ist in Arbeitslage 40 der Lüftungsvorrichtung 1 senkrecht zur Vertikalrichtung 50 orientiert. In Arbeitslage 40 der Lüftungsvorrichtung 1 verläuft die Blickrichtung 49 parallel zur ebenen Oberfläche des Bodens 7. Die Blickrichtung entspricht einer Entformungsrichtung bei der Entformung der Lüftungsvorrichtung 1. Hierbei wird eine von zwei Formen für die Lüftungsvorrichtung 1 in Richtung der Entformungsrichtung entfernt.

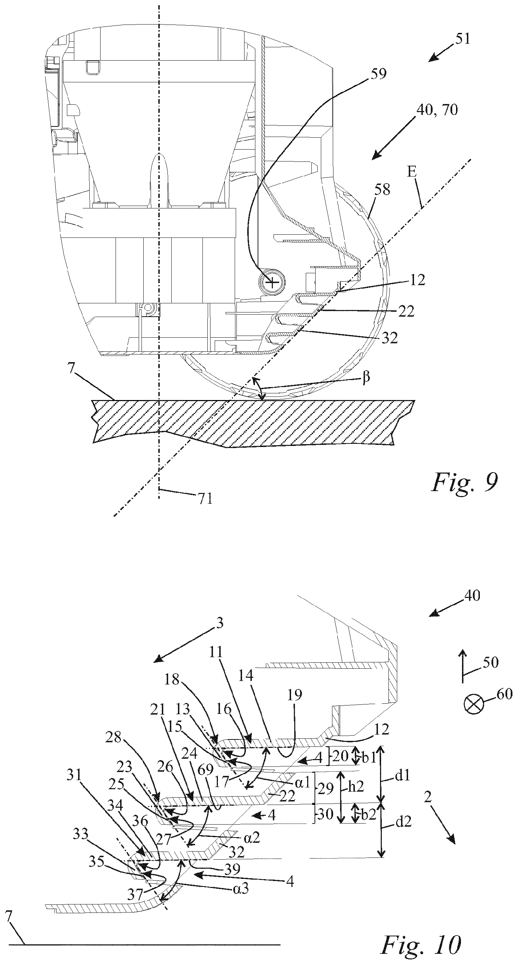

Wie in Fig. 9 dargestellt, liegen die Frontabschnitte 12, 22, 32 in einer gemeinsamen Ebene E. Die Ebene E ist in der Arbeitslage 40 der Lüftungsvorrichtung 1 in einem Winkel β von 30° bis 60° gegen den ebenen Boden 7 orientiert. Dadurch kann das Arbeitsgerät 51 um die Drehachse 59 der Räder 58 aus der Abstelllage 70 in eine Ziehlage gekippt werden. In der Ziehlage stützt sich das Arbeitsgerät 51 lediglich mittels der Räder 58 auf dem ebenen Boden 7 ab. In der Ziehlage ist das Arbeitsgerät auf den Rädern 58 ziehbar. Das Arbeitsgerät 51 weist eine Längsachse 71 auf. Die Längsachse 71 ist in der Abstelllage 70 senkrecht zum ebenen Boden 7 orientiert. In der Ziehlage ist die Längsachse 71 des Arbeitsgeräts 51 in einem Winkel von 20° bis 70° zum ebenen Boden 7 orientiert. Durch die schräge Orientierung der Frontabschnitte 12, 22 und 32 in der Abstelllage 70 steht die Lüftungsvorrichtung 1 beim Kippen des Arbeitsgeräts 51 in die Ziehlage so wenig hervor, dass die Lüftungsvorrichtung 1 nicht auf dem Boden 7 aufsetzt.

Fig. 10 zeigt eine Detaildarstellung der Lüftungsvorrichtung 1. Der Abweisungsabschnitt 13, 23, 33 weist einen Bereich 15, 25, 35 auf, der gegenüber dem Mittelabschnitt 14, 24, 34 in einem Winkel α1, α2, α3 von kleiner als 90°, im Ausführungsbeispiel in einem Winkel α1, α2, α3 von kleiner als 60° orientiert ist. Der Abweisungsabschnitt 13, 23, 33 ist zur Außenseite 2 der Lüftungsvorrichtung 1 hin geneigt. Der erste Abweisungsabschnitt 13 weist den ersten Bereich 15 auf. Der zweite Abweisungsabschnitt 23 weist den zweiten Bereich 25 auf. Der dritte Abweisungsabschnitt 33 weist den dritten Bereich 35 auf. Der erste Bereich 15 ist in einem ersten Winkel α1 von kleiner als 90°, im Ausführungsbeispiel von kleiner als 60° gegenüber dem ersten Mittelabschnitt 14 orientiert. Der zweite Bereich 25 ist in einem zweiten Winkel α2 von kleiner als 90°, im Ausführungsbeispiel von kleiner als 60° gegenüber dem zweiten Mittelabschnitt 24 orientiert. Der dritte Bereich 35 ist in einem dritten Winkel α3 von kleiner als 90°, im Ausführungsbeispiel von kleiner als 60° gegenüber dem dritten Mittelabschnitt 34 orientiert. Der Bereich 15, 25, 35 erstreckt sich in einer strichpunktiert dargestellten Ebene.

Der Abweisungsabschnitt 13, 23, 33 weist eine Außenfläche 17, 27, 37 auf. Der erste Abweisungsabschnitt 13 weist die erste Außenfläche 17 auf. Der zweite Abweisungsabschnitt 23 weist die zweite Außenfläche 27 auf. Der dritte Abweisungsabschnitt 33 weist die dritte Außenfläche 37 auf. Die Außenfläche 17, 27, 37 ist der Außenseite 3 der Lüftungsvorrichtung 1 zugewandt. Der Mittelabschnitt 14, 24, 34 weist eine Oberfläche 19, 69, 39 auf. Die Oberfläche 19, 69, 39 ist der Außenseite 2 der Lüftungsvorrichtung 1 zugewandt. Der erste Mittelabschnitt 14 weist die erste Oberfläche 19 auf. Der zweite Mittelabschnitt 24 weist die zweite Oberfläche 69 auf. Der dritte Mittelabschnitt 34 weist die dritte Oberfläche 39 auf. Die Oberfläche 19, 69, 39 ist eben.

Der Bereich 15, 25, 35 des Abweisungsabschnitts 13, 23, 33 ist zumindest ein Teil der der Außenseite 2 zugewandten Außenfläche 17, 27, 37 des Abweisungsabschnitts 13, 23, 33. Es kann auch vorgesehen sein, dass der Bereich die gesamte der Außenseite zugewandte Außenfläche des Abweisungsabschnitts ist. Der Winkel α1, α2, α3 ist zwischen der der Außenseite 2 zugewandten Außenfläche 17, 27, 37 des Bereichs 15, 25, 35 und der der Außenseite 2 zugewandten Oberfläche 19, 69, 39 des Mittelabschnitts 14, 24, 34 gemessen.

Wie in Fig. 10 dargestellt, weist die zweite Oberfläche 69 des zweiten Mittelabschnitts 24 der zweiten Lamelle 21 zu der ersten Oberfläche 19 des ersten Mittelabschnitts 14 der ersten Lamelle 11 einen ersten Abstand d1 auf. Der erste Abstand d1 ist in der Arbeitslage 40 der Lüftungsvorrichtung 1 in Richtung senkrecht zur Oberfläche des Bodens 7 gemessen. Der erste Abstand d1 ist in Arbeitslage 40 der Lüftungsvorrichtung 1 in Richtung der Vertikalrichtung 50 gemessen.

Die dritte Oberfläche 39 des dritten Mittelabschnitts 34 der dritten Lamelle 31 weist zu der zweite Oberfläche 69 des zweiten Mittelabschnitts 24 der zweiten Lamelle 21 einen zweiten Abstand d2 auf. Der zweite Abstand d2 ist in der Arbeitslage 40 der Lüftungsvorrichtung 1 in Richtung senkrecht zur Oberfläche des Bodens 7 gemessen. Der zweite Abstand d2 ist in Arbeitslage 40 der Lüftungsvorrichtung 1 in Richtung der Vertikalrichtung 50 gemessen.

Der Abweisungsabschnitt 13, 23 erstreckt sich in Arbeitslage 40 bezüglich der Vertikalrichtung 50 über einen Abweisungsbereich 20, 30. Der erste Abweisungsabschnitt 13 erstreckt sich über den ersten Abweisungsbereich 20. Der zweite Abweisungsabschnitt 23 erstreckt sich über den zweiten Abweisungsbereich 30. Der Abweisungsabschnitt 13, 23 erstreckt sich ausgehend von der der Außenseite 2 zugewandten Oberfläche 19, 69 des Mittelabschnitts 14, 24 in Richtung auf die Unterseite 6 der Lüftungsvorrichtung 1. Eine in Arbeitslage 40 in Vertikalrichtung 50 gemessene Abweisungshöhe b1, b2 des Abweisungsbereichs 20, 30 beträgt mindestens 20%, im Ausführungsbeispiel mindestens 30% des Abstands d1, d2. Der erste Abweisungsabschnitt 13 weist die erste Abweisungshöhe b1 auf. Der zweite Abweisungsabschnitt 23 weist die zweite Abweisungshöhe b2 auf. Die erste Abweisungshöhe b1 beträgt mindestens 20%, im Ausführungsbeispiel mindestens 30% des ersten Abstands d1. Die zweite Abweisungshöhe b2 beträgt mindestens 20%, im Ausführungsbeispiel mindestens 30% des zweiten Abstands d2.

Der Bereich 15, 25 des Abweisungsabschnitts 13, 23 erstreckt sich in Arbeitslage 40 der Lüftungsvorrichtung 1 in Vertikalrichtung 50 über mindestens 50%, im Ausführungsbeispiel über mindestens 60% des Abweisungsbereichs 20, 30. Der erste Bereich 15 des ersten Abweisungsabschnitts 13 erstreckt sich über mindestens 50%, im Ausführungsbeispiel über mindestens 60% des ersten Abweisungsbereichs 20. Der zweite Bereich 25 des zweiten Abweisungsabschnitts 23 erstreckt sich über mindestens 50%, im Ausführungsbeispiel über mindestens 60% des zweiten Abweisungsbereichs 30. Der erste Bereich 15 des ersten Abweisungsabschnitts 13 erstreckt sich in Vertikalrichtung 50 über mindestens 10%, im Ausführungsbeispiel über mindestens 15% des ersten Abstands d1. Der zweite Bereich 25 des zweiten Abweisungsabschnitts 23 erstreckt sich in Vertikalrichtung 50 über mindestens 10%, im Ausführungsbeispiel über mindestens 15% des zweiten Abstands d2.

Der Mittelabschnitt 14, 24, 34 und der Abweisungsabschnitt 13, 23, 33 weisen eine zur Außenseite 2 der Lüftungsvorrichtung 1 zeigende gemeinsame Oberfläche 16, 26, 36 auf. Der erste Mittelabschnitt 14 und der erste Abweisungsabschnitt 13 weisen die erste gemeinsame Oberfläche 16 auf. Der zweite Mittelabschnitt 24 und der zweite Abweisungsabschnitt 23 weisen die zweite gemeinsame Oberfläche 26 auf. Der dritte Mittelabschnitt 34 und der dritte Abweisungsabschnitt 33 weisen die dritte gemeinsame Oberfläche 36 auf. Die gemeinsame Oberfläche 16, 26, 36 ist in einem Querschnitt senkrecht zur Längsrichtung 60 konkav. Die mindestens eine Lamelle 11, 21, 31 erstreckt sich längs der Längsrichtung 60. Die gemeinsame Oberfläche 16, 26, 36 folgt im Querschnitt senkrecht zur Längsrichtung 60 der mindestens einen Lamelle 11, 21, 31 abschnittsweise einer Kreisbogenlinie. Die gemeinsame Oberfläche 16, 26, 36 des Abweisungsabschnitts 13, 23, 33 und des Mittelabschnitts 14, 24, 34 ist durch die Außenfläche 17, 27, 37 des Abweisungsabschnitts 13, 23, 33 und die Oberfläche 19, 69, 39 des Mittelabschnitts 14, 24, 34 gebildet.

Der Mittelabschnitt 14, 24, 34 der Lamelle 11, 21, 31 verläuft in der Arbeitslage 40 der Lüftungsvorrichtung 1 quer zur Vertikalrichtung 50, im Ausführungsbeispiel senkrecht zur Vertikalrichtung 50. Es sind mehrere Lamellen 11, 21, 31 mit einem Mittelabschnitt 14, 24, 34 und einem Abweisungsabschnitt 13, 23, 33 vorgesehen. Zumindest ein Abweisungsabschnitt 13, 23 ist so geformt und angeordnet, dass in der Arbeitslage 40 der Lüftungsvorrichtung 1 Wasser von der der Außenseite 2 der Lüftungsvorrichtung 1 zugewandten Außenfläche 17, 27 des Abweisungsabschnitts 13, 23 auf den Mittelabschnitt 24, 34 einer benachbarten Lamelle 21, 32 tropfen kann. In der Arbeitslage 40 kann Wasser von der ersten Außenfläche 17 des ersten Abweisungsabschnitts 13 auf den zweiten Mittelabschnitt 24 der benachbarten zweiten Lamelle 21 tropfen. In der Arbeitslage 40 kann Wasser von der zweiten Außenfläche 27 des zweiten Abweisungsabschnitts 23 auf den dritten Mittelabschnitt 34 der benachbarten dritten Lamelle 31 tropfen.

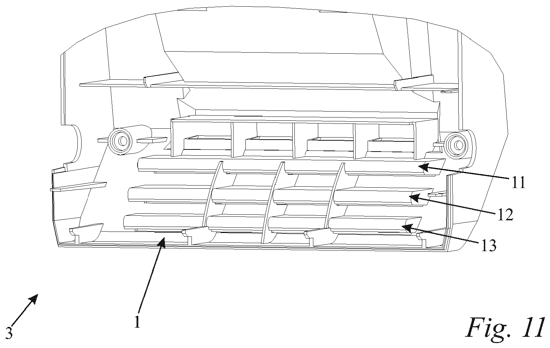

Die mehreren Lamellen 11, 21, 31 sind treppenartig angeordnet. In Richtung senkrecht zu einer von der Vertikalrichtung 50 und der Längsrichtung 60 aufgespannten Ebene sind die erste Lamelle 11, die zweite Lamelle 21 und die dritte Lamelle 31 versetzt zueinander angeordnet. Dies ist auch in Fig. 11 zu erkennen.

Wie in Fig. 10 dargestellt, ist der mindestens eine Abweisungsabschnitt 13, 23 auf der Innenseite 3 derart geformt, dass in der Arbeitslage 40 der Lüftungsvorrichtung 1 Wasser von einer der Innenseite 3 zugewandten Innenfläche 18, 28 des Abweisungsabschnitts 13, 23 auf die benachbarte Lamelle 21, 31 tropfen kann. Der erste Abweisungsabschnitt 13 ist auf der Innenseite 3 derart geformt, dass Wasser von der ersten Innenfläche 18 des ersten Abweisungsabschnitts 13 auf die benachbarte zweite Lamelle 21 tropfen kann. Der zweite Abweisungsabschnitt 23 ist auf der Innenseite 3 derart geformt, dass Wasser von der zweiten Innenfläche 28 des zweiten Abweisungsabschnitts 23 auf die benachbarte dritte Lamelle 31 tropfen kann.

Die Mittelabschnitte 14, 24, 34 der mehreren Lamellen 11, 21, 31 liegen in der Arbeitslage 40 der Lüftungsvorrichtung 1 in Vertikalrichtung 50 zumindest abschnittsweise nebeneinander, im Ausführungsbeispiel abschnittsweise parallel nebeneinander. Die erste Lamelle 11 liegt abschnittsweise parallel neben der zweiten Lamelle 21. Die zweite Lamelle 21 liegt abschnittsweise parallel neben der dritten Lamelle 31. Die mehreren Lamellen 21, 31 weisen die gleiche Form auf. Die zweite Lamelle 21 und die dritte Lamelle 31 weisen die gleiche Form auf.

Die mehreren Lamellen 11, 21, 31 umfassen die erste Lamelle 11 und die zweite Lamelle 21. Zumindest der zweite Frontabschnitt 22 der zweiten Lamelle 21 erstreckt sich über einen zweiten Frontbereich 29 von mindestens 30%, im Ausführungsbeispiel von mindestens 50% des ersten Abstands d1.

Die mehreren Lamellen 11, 21, 31 umfassen die dritte Lamelle 31. Der zweite Abweisungsbereich 30 erstreckt sich über mindestens 30% des zweiten Abstands d2.

Die zweite Lamelle 21 besitzt eine in Arbeitslage 40 in Vertikalrichtung 50 gemessene Höhe h2. Der zweite Frontbereich 29 erstreckt sich in Vertikalrichtung 50 in der Arbeitslage 40 über mindestens 40%, im Ausführungsbeispiel über mindestens 50% der zweiten Höhe h2 der zweiten Lamelle 21. Der zweite Abweisungsbereich 30 des zweiten Abweisungsabschnitts 23 der zweiten Lamelle 21 erstreckt sich in der Arbeitslage 40 der Lüftungsvorrichtung 1 in Vertikalrichtung 50 über mindestens 20%, im Ausführungsbeispiel über mindestens 30% der zweiten Höhe h2 der zweiten Lamelle 21. Der Bereich 25 des zweiten Abweisungsabschnitts 23 erstreckt sich in Vertikalrichtung 50 über mindestens 15%, im Ausführungsbeispiel über mindestens 20% der zweiten Höhe h2 der zweiten Lamelle 21.

## Patentansprüche

1. Lüftungsvorrichtung mit einem Spritzwasserschutz zur zumindest teilweisen Abweisung von Spritzwasser bei einem Vordringen von einer Außenseite (2) der Lüftungsvorrichtung (1) in Richtung auf eine Innenseite (3) der Lüftungsvorrichtung (1), wobei die Lüftungsvorrichtung (1) mehrere nebeneinander angeordnete Lamellen (11, 21, 31) umfasst, wobei jede der Lamellen (11, 21, 31) an der Außenseite (2) einen Frontabschnitt (12, 22, 32) aufweist, wobei zwischen den Frontabschnitten (12, 22, 32) Lüftungsschlitze (4) ausgebildet sind, wobei zumindest eine Lamelle (11, 21, 31) auf der Innenseite (3) einen Abweisungsabschnitt (13, 23, 33) aufweist, wobei der Abweisungsabschnitt (13, 23, 33) über einen Mittelabschnitt (14, 24, 34) mit dem Frontabschnitt (12, 22, 32) verbunden ist, wobei der Frontabschnitt (12, 22, 32) gegenüber dem Mittelabschnitt (14, 24, 34) abgewinkelt ist, wobei der Abweisungsabschnitt (13, 23, 33) gegenüber dem Mittelabschnitt (14, 24, 34) abgewinkelt ist, wobei die Lüftungsvorrichtung (1) in einer Arbeitslage (40) bezüglich der Vertikalrichtung (50) eine Oberseite (5) und eine Unterseite (6) besitzt, wobei sich der Frontabschnitt (12, 22, 32) in der Arbeitslage (40) vom Mittelabschnitt (14, 24, 34) in Richtung auf die Oberseite (5) erstreckt, wobei sich der Abweisungsabschnitt (13, 23, 33) in der Arbeitslage (40) vom Mittelabschnitt (14, 24, 34) in Richtung auf die Unterseite (6) erstreckt,
**dadurch gekennzeichnet, dass** der Abweisungsabschnitt (13, 23, 33) einen Bereich (15, 25, 35) aufweist, der gegenüber dem Mittelabschnitt (14, 24, 34) in einem Winkel (α1, α2, α3) von kleiner als 90° orientiert ist.

2. Lüftungsvorrichtung nach Anspruch 1,
**dadurch gekennzeichnet, dass** der Bereich (15, 25, 35) des Abweisungsabschnitts (13, 23, 33) und der Mittelabschnitt (14, 24, 34) in einem Winkel (α1, α2, α3) von kleiner als 60° zueinander orientiert sind.

3. Lüftungsvorrichtung nach Anspruch 1 oder 2,
**dadurch gekennzeichnet, dass** der Abweisungsabschnitt (13, 23, 33) einen zugeordneten Lüftungsschlitz (4) in Blickrichtung (49) von der Außenseite (2) zur Innenseite (3) zumindest teilweise überlappt.

4. Lüftungsvorrichtung nach einem der Ansprüche 1 bis 3,
**dadurch gekennzeichnet, dass** der Mittelabschnitt (14, 24, 34) und der Abweisungsabschnitt (13, 23, 33) eine zur Außenseite (2) zeigende gemeinsame Oberfläche (16, 26, 36) aufweisen, und dass die gemeinsame Oberfläche (16, 26, 36) in einem Querschnitt senkrecht zur Längsrichtung (60) der mindestens einen Lamelle (11, 21, 31) konkav ist.

5. Lüftungsvorrichtung nach Anspruch 4,
**dadurch gekennzeichnet, dass** die gemeinsame Oberfläche (16, 26, 36) im Querschnitt senkrecht zur Längsrichtung (60) der mindestens einen Lamelle (11, 21, 31) abschnittsweise einer Kreisbogenlinie folgt.

6. Lüftungsvorrichtung nach einem der Ansprüche 1 bis 5,
**dadurch gekennzeichnet, dass** der Mittelabschnitt (14, 24, 34) in der Arbeitslage (40) quer zur Vertikalrichtung (50), insbesondere senkrecht zur Vertikalrichtung (50) verläuft.

7. Lüftungsvorrichtung nach einem der Ansprüche 1 bis 6,
**dadurch gekennzeichnet, dass** mehrere Lamellen (11, 21, 31) mit einem Mittelabschnitt (14, 24, 34) und einem Abweisungsabschnitt (13, 23, 33) vorgesehen sind.

8. Lüftungsvorrichtung nach Anspruch 7,
**dadurch gekennzeichnet, dass** zumindest ein Abweisungsabschnitt (13, 23) so geformt und angeordnet ist, dass in der Arbeitslage (40) Wasser von einer der Außenseite (2) zugewandten Außenfläche (17, 27) des Abweisungsabschnitts (13, 23) auf den Mittelabschnitt (24, 34) einer benachbarten Lamelle (21, 31) tropfen kann.

9. Lüftungsvorrichtung nach Anspruch 7 oder 8,
**dadurch gekennzeichnet, dass** die mehreren Lamellen (11, 21, 31) treppenartig angeordnet sind.

10. Lüftungsvorrichtung nach einem der Ansprüche 7 bis 9,
**dadurch gekennzeichnet, dass** der mindestens eine Abweisungsabschnitt (13, 23) auf der Innenseite (3) derart geformt ist, dass in der Arbeitslage (40) Wasser von einer der Innenseite (3) zugewandten Innenfläche (18, 28) des Abweisungsabschnitts (13, 23) auf die benachbarte Lamelle (21, 31) tropfen kann.

11. Lüftungsvorrichtung nach einem der Ansprüche 7 bis 10,
**dadurch gekennzeichnet, dass** die Mittelabschnitte (14, 24, 34) der mehreren Lamellen (11, 21, 31) in der Arbeitslage (40) in Vertikalrichtung (50) zumindest abschnittsweise nebeneinander, insbesondere abschnittsweise parallel nebeneinander liegen.

12. Lüftungsvorrichtung nach einem der Ansprüche 7 bis 11,
**dadurch gekennzeichnet, dass** die mehreren Lamellen (21, 31) die gleiche Form aufweisen.

13. Lüftungsvorrichtung nach Anspruch 11 oder 12,
**dadurch gekennzeichnet, dass** die mehreren Lamellen (11, 21, 31) eine erste Lamelle (11) und eine zweite Lamelle (21) umfassen, dass eine der Außenseite (2) zugewandte zweite Oberfläche (69) des Mittelabschnitts (24) der zweiten Lamelle (21) zu einer der Außenseite (2) zugewandten ersten Oberfläche (19) des Mittelabschnitts (14) der ersten Lamelle (11) einen ersten Abstand (d1) aufweist, und dass sich zumindest der Frontabschnitt (22) der zweiten Lamelle (21) über einen Frontbereich (29) von mindestens 30% des ersten Abstands (d1) erstreckt.

14. Lüftungsvorrichtung nach einem der Ansprüche 11 bis 13,
**dadurch gekennzeichnet, dass** die mehreren Lamellen (11, 21, 31) eine dritte Lamelle (31) umfassen, dass die zweite Oberfläche (69) des Mittelabschnitts (24) der zweiten Lamelle (21) zu einer der Außenseite (2) zugewandten dritten Oberfläche (39) eines Mittelabschnitts (34) der dritten Lamelle (31) einen zweiten Abstand (d2) aufweist, und dass sich zumindest der Abweisungsabschnitt (23) der zweiten Lamelle (21) über einen Abweisungsbereich (30) von mindestens 30% des zweiten Abstands (d2) erstreckt.

15. Arbeitsgerät mit einer Lüftungsvorrichtung nach einem der Ansprüche 1 bis 14, **dadurch gekennzeichnet, dass** das Arbeitsgerät (51) für den Arbeitseinsatz in einer Abstelllage (70) auf einem ebenen Boden (7) abstellbar ist, und dass die Lüftungsvorrichtung (1) in der Abstelllage (70) des Arbeitsgeräts (51) in der Arbeitslage (40) ist.

16. Arbeitsgerät nach Anspruch 15,
**dadurch gekennzeichnet, dass** das Arbeitsgerät (51) bezüglich des Bodens (7) ein oberes Ende (52) und ein unteres Ende (53) aufweist, und dass die Lüftungsvorrichtung (1) am unteren Ende (53) des Arbeitsgeräts (51) angeordnet ist.

17. Arbeitsgerät nach Anspruch 15 oder 16,
**dadurch gekennzeichnet, dass** das Arbeitsgerät (51) ein Gehäuse (54) mit einer Gehäusewand (55) aufweist, dass die Lüftungsvorrichtung (1) Teil der Gehäusewand (55) ist, dass auf der Innenseite (3) der Lüftungsvorrichtung (1) das Gehäuseinnere (56) des Gehäuses (54) angeordnet ist, dass die Außenseite (2) der Lüftungsvorrichtung (1) außerhalb des Gehäuses (54) liegt, und dass das Arbeitsgerät (51) durch die Lüftungsvorrichtung (1) von der Außenseite (2) Luft auf die Innenseite (3) anzieht.

18. Arbeitsgerät nach einem der Ansprüche 15 bis 17,
**dadurch gekennzeichnet, dass** das Arbeitsgerät (51) mindestens ein elektrisch betriebenes Bauteil (57) aufweist, und dass die Lüftungsvorrichtung (1) in der Abstelllage (70) zumindest teilweise unterhalb aller elektrisch betriebener Bauteile (57) angeordnet ist.

19. Arbeitsgerät nach einem der Ansprüche 15 bis 18,
**dadurch gekennzeichnet, dass** das Arbeitsgerät (51) ein Hochdruckreiniger ist.

## Claims

1. Ventilation device with splash-water protection for at least partial diversion of splash water in the case of penetration from an outer side (2) of the ventilation device (1) in the direction of an inner side (3) of the ventilation device (1), wherein the ventilation device (1) comprises multiple lamellae (11, 21, 31) which are arranged one next to the other, wherein each of the lamellae (11, 21, 31) has a front portion (12, 22, 32) on the outer side (2), wherein ventilation slots (4) are formed between the front portions (12, 22, 32), wherein at least one lamella (11, 21, 31) has a diversion portion (13, 23, 33) on the inner side (3), wherein the diversion portion (13, 23, 33) is connected to the front portion (12, 22, 32) via a middle portion (14, 24, 34), wherein the front portion (12, 22, 32) is angled in relation to the middle portion (14, 24, 34), wherein the diversion portion (13, 23, 33) is angled in relation to the middle portion (14, 24, 34), wherein, in a working position (40), the ventilation device (1) has a top side (5) and a bottom side (6) in relation to the vertical direction (50), wherein, in the working position (40), the front portion (12, 22, 32) extends from the middle portion (14, 24, 34) in the direction of the top side (5), wherein, in the working position (40), the diversion portion (13, 23, 33) extends from the middle portion (14, 24, 34) in the direction of the bottom side (6),
**characterized in that** the diversion portion (13, 23, 33) has a region (15, 25, 35) which, in relation to the middle portion (14, 24, 34), is oriented at an angle (α1, α2, α3) of less than 90°.

2. Ventilation device according to Claim 1,
**characterized in that** the region (15, 25, 35) of the diversion portion (13, 23, 33) and the middle portion (14, 24, 34) are oriented at an angle (α1, α2, α3) of less than 60° to one another.

3. Ventilation device according to Claim 1 or 2,
**characterized in that** the diversion portion (13, 23, 33) at least partially overlaps an associated ventilation slot (4) in a viewing direction (49) from the outer side (2) to the inner side (3).

4. Ventilation device according to one of Claims 1 to 3,
**characterized in that** the middle portion (14, 24, 34) and the diversion portion (13, 23, 33) have a common surface (16, 26, 36) which faces in the direction of the outer side (2), and **in that** the common surface (16, 26, 36) is concave in a cross section perpendicular to the longitudinal direction (60) of the at least one lamella (11, 21, 31).

5. Ventilation device according to Claim 4,
**characterized in that** the common surface (16, 26, 36) sectionally follows a circular-arc line in the cross section perpendicular to the longitudinal direction (60) of the at least one lamella (11, 21, 31).

6. Ventilation device according to one Claims 1 to 5,
**characterized in that**, in the working position (40), the middle portion (14, 24, 34) extends transversely to the vertical direction (50), in particular perpendicularly to the vertical direction (50).

7. Ventilation device according to one Claims 1 to 6,
**characterized in that** provision is made of multiple lamellae (11, 21, 31) having a middle portion (14, 24, 34) and a diversion portion (13, 23, 33).

8. Ventilation device according to Claim 7,
**characterized in that** at least one diversion portion (13, 23) is shaped and arranged in such a way that, in the working position (40), water can drip from an outer surface (17, 27), facing towards the outer side (2), of the deflection portion (13, 23) onto the middle portion (24, 34) of an adjacent lamella (21, 31).

9. Ventilation device according to Claim 7 or 8,
**characterized in that** the multiple lamellae (11, 21, 31) are arranged in a staircase-like manner.

10. Ventilation device according to one of Claims 7 to 9,
**characterized in that** the at least one diversion portion (13, 23), on the inner side (3), is shaped in such a way that, in the working position (40), water can drip from an inner surface (18, 28), facing towards the inner side (3), of the deflection portion (13, 23) onto the adjacent lamella (21, 31).

11. Ventilation device according to one of Claims 7 to 10,
**characterized in that**, in the working position (40), the middle portions (14, 24, 34) of the multiple lamellae (11, 21, 31) at least sectionally lie one next to the other, in particular sectionally lie one next to the other in a parallel manner, in the vertical direction (50).

12. Ventilation device according to one of Claims 7 to 10,
**characterized in that** the multiple lamellae (21, 31) have the same shape.

13. Ventilation device according to Claim 11 or 12,
**characterized in that** the multiple lamellae (11, 21, 31) comprise a first lamella (11) and a second lamella (21), **in that** a second surface (69), facing towards the outer side (2), of the middle portion (24) of the second lamella (21) is at a first distance (d1) from a first surface (19), facing towards the outer side (2), of the middle portion (14) of the first lamella (11), and **in that** at least the front portion (22) of the second lamella (21) extends over a front range (29) of at least 30% of the first distance (d1).

14. Ventilation device according to one of Claims 11 to 13,
**characterized in that** the multiple lamellae (11, 21, 31) comprise a third lamella (31), **in that** the second surface (69) of the middle portion (24) of the second lamella (21) is at a second distance (d2) from a third surface (39), facing towards the outer side (2), of a middle portion (34) of the third lamella (31), and **in that** at least the deflection portion (23) of the second lamella (21) extends over a deflection range (30) of at least 30% of the second distance (d2).

15. Working appliance having a ventilation device according to one of Claims 1 to 14,
**characterized in that**, for working use, the working appliance (51) is able to be set down on an even floor/ground (7) in a set-down position (70), and **in that**, in the set-down position (70) of the working appliance (51), the ventilation device (1) is in the working position (40).

16. Working appliance according to Claim 15,
**characterized in that** the working appliance (51) has an upper end (52) and a lower end (53) in relation to the floor/ground (7), and **in that** the ventilation device (1) is arranged on the lower end (53) of the working appliance (51).

17. Working appliance according to Claim 15 or 16,
**characterized in that** the working appliance (51) has a housing (54) with a housing wall (55), **in that** the ventilation device (1) is part of the housing wall (55), **in that** the housing interior (56) of the housing (54) is situated on the inner side (3) of the ventilation device (1), **in that** the outer side (2) of the ventilation device (1) is situated outside the housing (54), and **in that** the working appliance (51) draws in air to the inner side (3) through the ventilation device (1) from the outer side (2).

18. Working appliance according to one of Claims 15 to 17,
**characterized in that** the working appliance (51) has at least one electrically operated component (57), and **in that**, in the set-down position (70), the ventilation device (1) is arranged at least partially below all the electrically operated components (57).

19. Working appliance according to one of Claims 15 to 18,
**characterized in that** the working appliance (51) is a high-pressure cleaner.

## Revendications

1. Dispositif de ventilation avec une protection contre les projections d'eau pour repousser au moins partiellement les projections d'eau lors d'une pénétration depuis un côté extérieur (2) du dispositif de ventilation (1) en direction d'un côté intérieur (3) du dispositif de ventilation (1), le dispositif de ventilation (1) comprenant plusieurs lamelles (11, 21, 31) disposées les unes à côté des autres, chacune des lamelles (11, 21, 31) présentant sur le côté extérieur (2) une partie avant (12, 22, 32), des fentes d'aération (4) étant formées entre les parties avant (12, 22, 32), au moins une lamelle (11, 21, 31) présentant sur le côté intérieur (3) une partie de renvoi (13, 23, 33), la partie de renvoi (13, 23, 33) étant reliée par une partie centrale (14, 24, 34), la partie avant (12, 22, 32), la partie avant (12, 22, 32) étant coudée par rapport à la partie centrale (14, 24, 34), la partie de renvoi (13, 23, 33) étant coudée par rapport à la partie centrale (14, 24, 34), le dispositif de ventilation (1) ayant, dans une position de travail (40), par rapport à la direction verticale (50), un côté supérieur (5) et un côté inférieur (6), la partie avant (12, 22, 32) s'étendant dans la position de travail (40) depuis la partie centrale (14, 24, 34) en direction du côté supérieur (5), la partie de renvoi (13, 23, 33) s'étendant dans la position de travail (40) depuis la partie centrale (14, 24, 34) en direction du côté inférieur (6),
**caractérisé en ce que** la partie de renvoi (13, 23, 33) comprend une zone (15, 25, 35) orientée par rapport à la partie centrale (14, 24, 34) selon un angle (αl, α2, α3) inférieur à 90°.

2. Dispositif de ventilation selon la revendication 1,
**caractérisé en ce que** la zone (15, 25, 35) de la partie de renvoi (13, 23, 33) et la partie centrale (14, 24, 34) sont orientées l'une par rapport à l'autre selon un angle (α1, α2, α3) inférieur à 60°.

3. Dispositif de ventilation selon la revendication 1 ou 2,
**caractérisé en ce que** la partie de renvoi (13, 23, 33) chevauche au moins partiellement une fente de ventilation associée (4) dans la direction d'observation (49) allant de l'extérieur (2) vers l'intérieur (3).

4. Dispositif de ventilation selon l'une des revendications 1 à 3,
**caractérisé en ce que** la partie centrale (14, 24, 34) et la partie de renvoi (13, 23, 33) présentent une surface commune (16, 26, 36) orientée vers le côté extérieur (2), et **en ce que** la surface commune (16, 26, 36) est concave dans une section transversale perpendiculaire à la direction longitudinale (60) de l'au moins une lamelle (11, 21, 31).

5. Dispositif de ventilation selon la revendication 4,
**caractérisé en ce que** la surface commune (16, 26, 36), en section transversale perpendiculaire à la direction longitudinale (60) de l'au moins une lamelle (11, 21, 31), suit partiellement un arc de cercle.

6. Dispositif de ventilation selon l'une des revendications 1 à 5,
**caractérisé en ce que** la partie centrale (14, 24, 34) s'étend, en position de travail (40), transversalement à la direction verticale (50), notamment perpendiculairement à la direction verticale (50).

7. Dispositif de ventilation selon l'une des revendications 1 à 6,
**caractérisé en ce qu'**il est prévu plusieurs lamelles (11, 21, 31) comportant une partie centrale (14, 24, 34) et une partie de renvoi (13, 23, 33).

8. Dispositif de ventilation selon la revendication 7,
**caractérisé en ce qu'**au moins une partie de renvoi (13, 23) est formée et agencée de telle sorte que, dans la position de travail (40), l'eau puisse s'égoutter d'une surface extérieure (17, 27) de la partie de renvoi (13, 23) tournée vers le côté extérieur (2) sur la partie centrale (24, 34) d'une lamelle adjacente (21, 31).

9. Dispositif de ventilation selon la revendication 7 ou 8,
**caractérisé en ce que** les lamelles de la pluralité de lamelles (11, 21, 31) sont agencées à la manière d'un escalier.

10. Dispositif de ventilation selon l'une des revendications 7 à 9,
**caractérisé en ce que** l'au moins une partie de renvoi (13, 23) est formée sur le côté intérieur (3) de telle sorte qu'en position de travail (40), de l'eau puisse s'égoutter depuis une surface interne (18, 28) de la partie de renvoi (13, 23) tournée vers le côté intérieur (3) sur la lamelle adjacente (21, 31).

11. Dispositif de ventilation selon l'une des revendications 7 à 10,
**caractérisé en ce que** les parties centrales (14, 24, 34) de la pluralité de lamelles (11, 21, 31) sont, en position de travail (40), juxtaposées au moins partiellement dans la direction verticale (50), en particulier partiellement parallèles.

12. Dispositif de ventilation selon l'une des revendications 7 à 11,
**caractérisé en ce que** les lamelles de la pluralité lamelles (21, 31) présentent la même forme.

13. Dispositif de ventilation selon la revendication 11 ou 12,
**caractérisé en ce que** la pluralité de lamelles (11, 21, 31) comprend une première lamelle (11) et une deuxième lamelle (21), **en ce qu'**une deuxième surface (69), tournée vers le côté extérieur (2), de la partie centrale (24) de la deuxième lamelle (21) présente une première distance (d1) par rapport à une première surface (19), tournée vers le côté extérieur (2), de la partie centrale (14) de la première lamelle (11), et **en ce qu'**au moins la partie avant (22) de la deuxième lamelle (21) s'étend sur une zone frontale (29) d'au moins 30% de la première distance (d1).

14. Dispositif de ventilation selon l'une quelconque des revendications 11 à 13, **caractérisé en ce que** la pluralité de lamelles (11, 21, 31) comprend une troisième lamelle (31), **en ce que** la deuxième surface (69) de la partie centrale (24) de la deuxième lamelle (21) est à une deuxième distance (d2) par rapport à une troisième surface (39), tournée vers l'extérieur (2), d'une partie centrale (34) de la troisième lamelle (31), et **en ce qu'**au moins la partie de renvoi (23) de la deuxième lamelle (21) s'étend sur une zone de renvoi (30) d'au moins 30% de la deuxième distance (d2).

15. Appareil de travail comportant un dispositif de ventilation selon l'une des revendications 1 à 14,
**caractérisé en ce que** l'appareil de travail (51) est apte à être déposé sur un sol plat (7) dans une position de stationnement (70) pour le travail, et **en ce que** le dispositif de ventilation (1) est en position de travail (40) dans la position de stationnement (70) de l'appareil de travail (51).

16. Appareil de travail selon la revendication 15,
**caractérisé en ce que** l'appareil de travail (51) présente, par rapport au socle (7), une extrémité supérieure (52) et une extrémité inférieure (53), et **en ce que** le dispositif de ventilation (1) est agencé à l'extrémité inférieure (53) de l'appareil de travail (51).

17. Appareil de travail selon la revendication 15 ou 16,
**caractérisé en ce que** l'appareil de travail (51) présente un boîtier (54) ayant une paroi de boîtier (55), **en ce que** le dispositif de ventilation (1) fait partie de la paroi de boîtier (55), **en ce que** sur le côté intérieur (3) du dispositif de ventilation (1) est sur le côté intérieur (56) de boîtier du boîtier (54), **en ce que** le côté extérieur (2) du dispositif de ventilation (1) est situé à l'extérieur du boîtier (54), et **en ce que** l'appareil de travail (51) aspire de l'air du côté extérieur (2) vers le côté intérieur (3) par le dispositif de ventilation (1).

18. Appareil de travail selon l'une quelconque des revendications 15 à 17,
**caractérisé en ce que** l'appareil de travail (51) comporte au moins un composant (57) à fonctionnement électrique, et **en ce que** le dispositif de ventilation (1) est, dans la position de stationnement (70), disposé au moins partiellement en dessous de tous les composants (57) à fonctionnement électrique.

19. Appareil de travail selon l'une quelconque des revendications 15 à 18,
**caractérisé en ce que** l'appareil de travail (51) est un nettoyeur haute pression.
